(19) Europäisches Patentamt / European Patent Office / Office européen des brevets

(11) **EP 3 734 364 A1**

(12) **EUROPEAN PATENT APPLICATION**

(43) Date of publication:
04.11.2020 Bulletin 2020/45

(51) Int Cl.:
*G03F 7/20* (2006.01)  *G05B 19/418* (2006.01)
*H01L 21/66* (2006.01)

(21) Application number: 19171535.8

(22) Date of filing: 29.04.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventors:
• HAUPTMANN, Marc
5500 AH Veldhoven (NL)
• ISMAIL, Amir Bin
5500 AH Veldhoven (NL)
• RAHMAN, Rizvi
5500 AH Veldhoven (NL)

(74) Representative: ASML Netherlands B.V.
Corporate Intellectual Property
P.O. Box 324
5500 AH Veldhoven (NL)

(54) **METHOD FOR GENERATING A CONTROL SCHEME AND DEVICE MANUFACTURING METHOD**

(57)    A method for generating a control scheme for a device manufacturing process, the method comprising: obtaining a measurement data time series of a plurality of substrates on which an exposure step and a process step have been performed; transforming the measurement data time series to obtain frequency domain data; and determining, using the frequency domain data, a control scheme to be performed on subsequent substrates.

## Fig. 2

**Description**

BACKGROUND

Field of the Invention

The present invention relates to generating control schemes and device manufacturing using the control schemes.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. The patterned radiation-sensitive layer is then developed and a process apparatus, such as an etcher, is used to fix the pattern in the substrate.

To create an electronic device, it is necessary to repeat the exposure and fixing steps many times, e.g. up to 30, to create the different layers of a device. Each layer is applied to a batch, also known as a lot, of substrates at a time. To improve yield, i.e. the fraction of devices that are functional, it is known to use measurements performed on substrates to adjust the exposures of subsequent substrates in the same batch or later batches to which the same process is applied, for example to reduce errors in overlay, focus or CD. This process is known as Automated Process Control. Where measurements of multiple substrates are available, a weighted moving average of the measurements is often used as the input to the process control.

Whilst APC improves yield, the measurements (often referred to a metrology) that provide the necessary input to the control loop are time consuming. Therefore, it is necessary to compromise between throughput and yield or to provide additional metrology tools, which are expensive. Determining an optimum metrology and control strategy is difficult, and often has to be done by trial and error. Improvements in the effectiveness of the control loop are also desirable.

SUMMARY OF THE INVENTION

The present invention aims to provide improved automated process control methods for use in lithographic manufacturing processes.

The invention in a first aspect provides a method for generating a control scheme for a device manufacturing process, the method comprising:

obtaining a measurement data time series of a plurality of substrates on which an exposure step and optionally a process step have been performed;
transforming the measurement data time series to obtain frequency domain data; and
determining, using the frequency domain data, a control scheme to be performed on subsequent substrates.

The invention in a second aspect provides a device manufacturing process comprising:

exposing an initial set of substrates using a lithographic apparatus;
optionally performing a process step on the initial set of substrates;
measuring a parameter of a plurality of the initial set of substrates to obtain a measurement data time series;
transforming the measurement data time series to obtain frequency domain data;
determining, using the frequency domain data, a control scheme to be performed on subsequent substrates; and
exposing subsequent substrates using the control scheme.

BRIEF DESCRIPTION OF THE DRAWINGS/FIGURES

Embodiments of the invention will now be described, by way of example, with reference to the accompanying drawings in which:

Figure 1 depicts a lithographic apparatus together with other apparatuses forming a production facility for semiconductor devices;

Figure 2 depicts an automated process control method according to an embodiment of the invention;

Figure 3 depicts a principle of operation of an automated process control method according to an embodiment of the invention;

Figure 4 depicts phase effects of a time-varying control signal on a time-varying error signal;

Figure 5 depicts an automated process control method according to another embodiment of the invention;

Figure 6 depicts an automated process control method according to another embodiment of the invention;

Figure 7 depicts a breakdown of an error between contributors and components of variation (static average component, slow moving capturable lot-to-lot variation component and fast moving, non-capturable lot-to-lot variation component);

Figure 8 depicts a forecast of overlay values using different time filters;

Figure 9 depicts a forecast of overlay values using different sampling rates;

Figure 10 depicts a process to calculate aliasing error;

Figure 11 depicts a process to apply a aliasing correction based on the calculated aliasing error

Figure 12 depicts the distribution of a dense sampling scheme over a plurality of lots;

Figures 13A to G depict temporal grouping of parameters according to similarities in their frequency spectrum, the corresponding average frequency spectra for each parameter group and the contribution of each parameter to the average fingerprint; and

Figures 14A to E depict reconstruction of the lot-to-lot (stacked) fingerprints for each parameter group (split into chuck 1&2 wafer and average field fingerprints), as well as the corresponding frequency spectra and transfer functions of the optimized time filters per group.

## DETAILED DESCRIPTION

Before describing embodiments of the invention in detail, it is instructive to present an example environment in which embodiments of the present invention may be implemented.

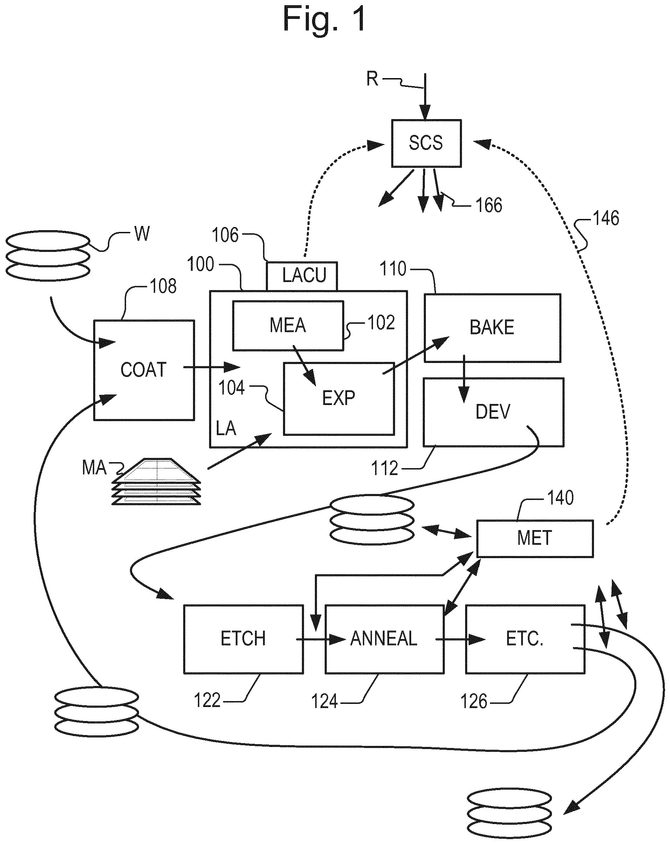

Figure 1 illustrates a typical layout of a semiconductor production facility. A lithographic apparatus 100 applies a desired pattern onto a substrate. A lithographic apparatus is used, for example, in the manufacture of integrated circuits (ICs). In that instance, a patterning device MA, which is alternatively referred to as a mask or a reticle, comprises a circuit pattern of features (often referred to as "product features") to be formed on an individual layer of the IC. This pattern is transferred onto a target portion (e.g., comprising part of, one, or several dies) on a substrate W (e.g., a silicon wafer) via exposure 104 of the patterning device onto a layer of radiation-sensitive material (resist) provided on the substrate. In general, a single substrate will contain a network of adjacent target portions that are successively patterned.

Known lithographic apparatus irradiate each target portion by illuminating the patterning device while synchronously positioning the target portion of the substrate at an image position of the patterning device. An irradiated target portion of the substrate is referred to as an "exposure field", or simply "field". The layout of the fields on the substrate is typically a network of adjacent rectangles aligned in accordance to a Cartesian two-dimensional coordinate system (e.g. aligned along an X and an Y-axis, both axes being orthogonal to each other).

A requirement on the lithographic apparatus is an accurate reproduction of the desired pattern onto the substrate. The positions and dimensions of the applied product features need to be within certain tolerances. Position errors may occur due to an overlay error (often referred to as "overlay"). The overlay is the error in placing a first product feature within a first layer relative to a second product feature within a second layer. The lithographic apparatus minimizes the overlay errors by aligning each wafer accurately to a reference prior to patterning. This is done by measuring positions of alignment marks which are applied to the substrate. Based on the alignment measurements the substrate position is controlled during the patterning process in order to prevent occurrence of overlay errors.

An error in a critical dimension (CD) of the product feature may occur when the applied dose associated with the exposure 104 is not within specification. For this reason the lithographic apparatus 100 must be able to accurately control the dose of the radiation applied to the substrate. CD errors may also occur when the substrate is not positioned correctly with respect to a focal plane associated with the pattern image. Focal position errors are commonly associated with non-planarity of a substrate surface. The lithographic apparatus minimizes these focal positon errors by measuring the substrate surface topography using a level sensor prior to patterning. Substrate height corrections are applied during subsequent patterning to assure correct imaging (focusing) of the patterning device onto the substrate.

To verify the overlay and CD errors associated with the lithographic process the patterned substrates are inspected by a metrology apparatus 140. A common example of a metrology apparatus is a scatterometer. The scatterometer conventionally measures characteristics of dedicated metrology targets. These metrology targets are representative of the product features, except that their dimensions are typically larger in order to allow accurate measurement. The scatterometer measures the overlay by detecting an asymmetry of a diffraction pattern associated with an overlay metrology target. Critical dimensions are measured by analysis of a diffraction pattern associated with a CD metrology target. Another example of a metrology tool is an electron beam (e-beam) based inspection tool such as a scanning electron microscope (SEM).

Within a semiconductor production facility, lithographic apparatus 100 and metrology apparatus 140 form part of a "litho cell" or "litho cluster". The litho cluster comprises also a coating apparatus 108 for applying photosensitive resist to substrates W, a baking apparatus 110, a developing apparatus 112 for developing the exposed pattern into a physical resist pattern, an etching station 122, apparatus 124 performing a post-etch annealing step and possibly further processing apparatuses, 126, etc... The metrology apparatus is configured to inspect substrates after development (112) or after further processing (e.g. etching). The various apparatus within the litho cell are controlled by a supervisory control system SCS, which issues control signals 166 to control the lithographic apparatus via lithographic apparatus control unit LACU 106 to perform recipe R. The SCS allows the different apparatuses to be operated giving maximum throughput and product yield. An important control mechanism is the feedback 146 of the metrology apparatus 140 to the various apparatus (via the SCS), in particular to the lithographic apparatus 100. Based on the characteristics of the metrology feedback corrective actions are determined to improve processing quality of subsequent substrates.

The performance of a lithographic apparatus is conventionally controlled and corrected by methods such as automated process control (APC) described for example in US2012008127A1. The automated process control techniques use measurements of metrology targets applied to the substrate. A Manufacturing Execution System (MES) schedules the APC measurements and communicates the measurement results to a data processing unit. The data processing unit translates the characteristics of the measurement data to a recipe comprising instructions for the lithographic apparatus. This method is very effective in suppressing drift phenomena associated with the lithographic apparatus.

The processing of metrology data to generate corrective actions performed by the processing apparatus is important for semiconductor manufacturing. In addition to the metrology data also characteristics of individual patterning devices, substrates, processing apparatus and other context data may be needed to further optimize the manufacturing process. The framework wherein available metrology and context data is used to optimize the lithographic process as a whole is commonly referred to as part of holistic lithography. For example context data relating to CD errors on a reticle may be used to control various apparatus (lithographic apparatus, etching station) such that said CD errors will not affect the yield of the manufacturing process. Subsequent metrology data may then be used to verify the effectiveness of the control strategy and further corrective actions may be determined.

Automated process control often aims to control, e.g. reduce, lot-to-lot variations in substrate fingerprints in process parameters such as overlay, focus and CD. A "fingerprint" is the variation of a parameter (or error in a parameter) over area. An intrafield fingerprint is the variation across a field and in some cases will be the same for all the fields on a substrate. A substrate fingerprint is the variation across the whole substrate. In some cases, a substrate fingerprint can be separated into an intrafield fingerprint and a interfield fingerprint. The present invention concerns all types of fingerprint.

A conventional APC correction in high volume manufacturing (HVM) conditions is based on feedback. Measurements obtained from a plurality of preceding substrates $W_{N-1}$ to $W_{N-x}$ are used to control one or more process parameters of a current substrate $W_N$. The measurements, or correction parameters derived from individual measurements, are grouped together and fed into a moving average (MA), for example an exponentially weighted moving average (EWMA).

In more sophisticated cases, a certain MA is applied for interfield and intrafield corrections and another type of MA for high-order (such as correction per field) corrections. In even more sophisticated cases, certain layers get fed some of the corrections determined on a previous layer if the two layers are expected to display very similar fingerprints. However, even these schemes have several drawbacks.

Currently, setting up an APC control strategy such as an after-etch overlay control strategy is a very cumbersome and convoluted process, as it involves multiple parallel control loops utilizing and combining after-development and after-etch overlay data. The complexity arises from the different metrology load constraints and the delays introduced between after-development and after-etch measurements by the substrate processing (e.g. the etch and other fixing steps). In this disclosure, the term "after-etch" should be read as encompassing measurements taken after other process steps. Some building blocks exist to select models and samplings based on after-development data, but sampling frequency and time filter settings are currently only "guestimated" using computational heavy run-to-run simulations or optimized in a reactive way through statistical process control (SPC) (if optimized at all). Furthermore, currently existing functionality does not take into account the interdependencies between after development, metrology to device and higher order after etch fingerprints.

WO 2018228750 A1, which document is hereby incorporated by reference in its entirety, describes a generalized application, where metrology load and correction models are optimized for different time domains of lot-to-lot variation. WO '7850 describes methods to fine tune APC feedback loops for reduced lot-to-lot variation in process parameters and/or allow decreased metrology sampling. Metrology measurements obtained from a plurality of preceding substrates $W_{N-1}$ to $W_{N-x}$ is used together with status data to control one or more process parameters of a current substrate $W_N$.

Status data relates to conditions pertaining in one or more process tools, such as an etcher or annealer, when relevant layers on substrates $W_{N-1}$ to $W_{N-x}$ were processed by those tools.

The information derived from metrology measurements can be provided in the format of a data time series, that is a series of data values each associated with a time. It should be noted that the time associated with a data value is not necessarily the time at which the measurement was made but rather the time at which a relevant manufacturing step, e.g. an exposure, was performed on the structure or target measured. The aim of the metrology steps and of providing the metrology data as a time series is to infer time variation in conditions prevailing in a manufacturing tool, e.g. a lithographic apparatus. The information derived from metrology measurements can be the actual measurement results themselves or modeled parameters - such as translation, rotation, scaling, etc. - derived from the actual measurement results.

A difficulty in applying known automatic process control methods is that information on how the different measured errors - for example after-develop inspection (ADI), after-etch inspection (AEI) and metrology-to-device (MTD) offsets - contribute to after-etch overlay is lacking. In currently available budget breakdown methodologies, the lot-to-lot (L2L) variation is treated as an indivisible factor, whereas part of it could be controlled for with the correct control strategy, making it difficult to select the right building blocks of the strategy. As a result, a control loop set up according to conventional approaches might either not be sufficient to harvest the full (or sufficient) correction potential, or alternatively might be too complex and costly with respect to the available correction potential. Current strategies to assess these contributions and their variations in a control context rely on computationally costly run-to-run (R2R) simulations, which also lack coverage of the available parameter space to harvest the full optimization potential.

Another disadvantage of known automatic process control methods is that it is difficult to optimize the sampling rate of the different measurement processes so as to balance correction potential and metrology load. Currently these settings are based on experience and often tuned reactively (if at all) as part of the statistical process control (SPC), because brute force run-to-run simulations may be too time consuming to run for a multitude of potential settings with sufficient coverage. Also run-to-run simulations will always lack the detailed insight as to what makes an optimal setting optimal in order to verify its validity. In unlucky cases, the sampling rate of the input data might be in the same range as the dominant variation, effectively amplifying the noise and dialing it back into the control loop as low-frequency or even average content.

Another disadvantage of known automatic process control methods is that it is difficult to choose appropriate time filter settings to optimally capture wanted and suppress unwanted lot-to-lot variation. Whereas for simple, single parameter filters, it might be sufficient to brute force optimize the parameter value, other more complex filters might be needed to harvest the full correction potential with respect to lot-to-lot variation. For the design and optimization of these filters, the brute force approach is too inefficient and error prone (due to limitations in coverage of the parameter space), and more insight on the behavior of these filters in the frequency domain is needed.

For the latter two disadvantages, it is also desirable to separate transient (convergence) effects from steady-state (stable run-to-run) effects. Especially on short datasets, these effects will be intermixed in classical run-to-run simulations, leading to potentially wrong conclusions for the long-term.

Current model and sampling advice strategies treat some variations, e.g. lot-to-lot variations, as indivisible and do not distinguish the capturable and non-capturable (in a run-to-run context) portions. This might lead to suboptimal model and sampling selections for different run-to-run situations in high-volume manufacturing (HVM), utilizing different sampling rates and time-filtering strategies.

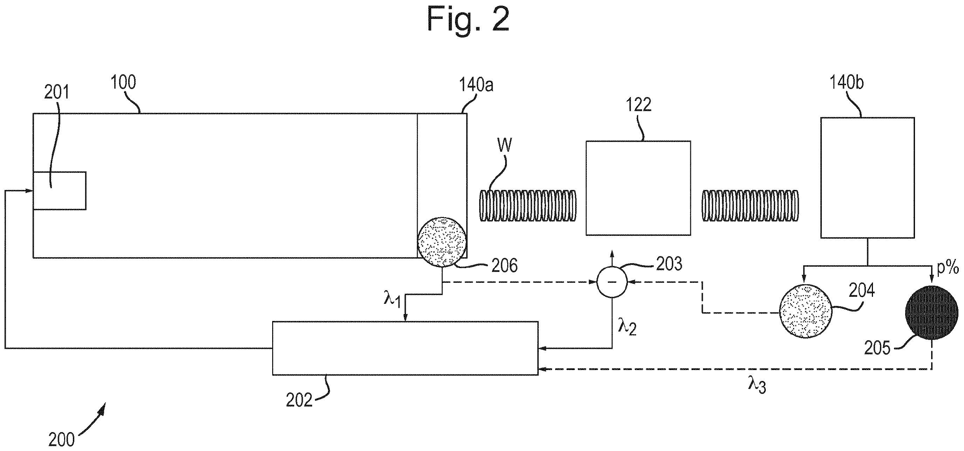

Figure 2 depicts a control scheme 200 in which the present invention can be applied. A lithography apparatus 100 exposes substrates which are then developed and measured by first metrology device 140a using after-development sampling scheme 206. In some cases all substrates are measured after development but in other cases only a sample are measured. The exposed wafers are processed by process tool 122 (e.g. an etcher) to perform a pattern transfer step. Second metrology device 140b measures the substrates after the pattern transfer step. A certain proportion m % of the substrates may be measured using a sparse sampling scheme 204 and another proportion p % may be measured using a dense sampling scheme 205. Proportions m % and p % may be different and need not add up to 100 %.

Measurements from first metrology device 140a and second metrology device 140b may be compared 203 and used to generate process corrections that are applied to the pattern transfer step.

A controller 202 receives the measurements from the first metrology device 140a, the process corrections and measurements for the second metrology device 140b with respective time constants $\lambda_1$, $\lambda_2$ and $\lambda_3$. Controller 202 applies filters to its inputs and provides control signals (corrections) to the lithography apparatus 100 via control interface 201. Other arrangements are possible as discussed below.

The present invention proposes a methodology to reduce an error of interest which may include various of the following building blocks. In particular there are three main steps.

In a first main step, a strategy is built by identifying the relevant contributors to the error and recommending an appropriate set of sampling rates and time filter settings per contributor, using existing models and sampling schemes being utilized. A breakdown of the on-product overlay (OPO) or other measure of interest is provided per contributor, with an extended degree of granularity at the lot-to-lot level. Such a breakdown makes it possible to assess which part of the lot-to-lot variation can be captured with the current timefilter, which part of the theoretically capturable variation is not captured by the current timefilter, and which portion is not capturable at all via a feedback loop, requiring other means of control.

In a second main step, the strategy is optimized, by adjusting model parameters (and the corresponding run-to-run control parameters) and sampling plans (e.g. the number of points & wafers as well as candidate positions, as well as distribution of the points over the lots) to the frequency characteristics of the underlying lot-to-lot variation.

For the sampling aspect, it is also important in this step to balance (or co-optimize) the spatial sampling density of the measurements on the wafers to be measured against the temporal sampling frequency in order to minimize said error of interest.

The model optimization should take into account different temporal behavior of the different parameters, while keeping the complexity of the control loop at acceptable levels, i.e. by grouping model parameters that would receive similar time filter settings or require similar sampling densities, schemes or rates, or eliminating model parameters, that would contribute more noise than actual correctable content to the control loop.

In a third main step, the obtained recommendations can optionally be validated and fine-tuned using a selected, narrow set of regular run-to-run simulations.

In an embodiment, the first main step can be realized by the following substeps.

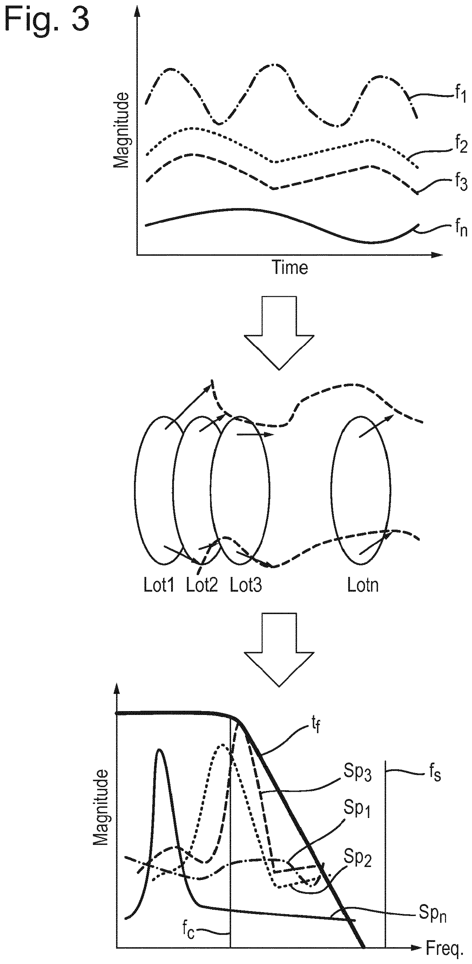

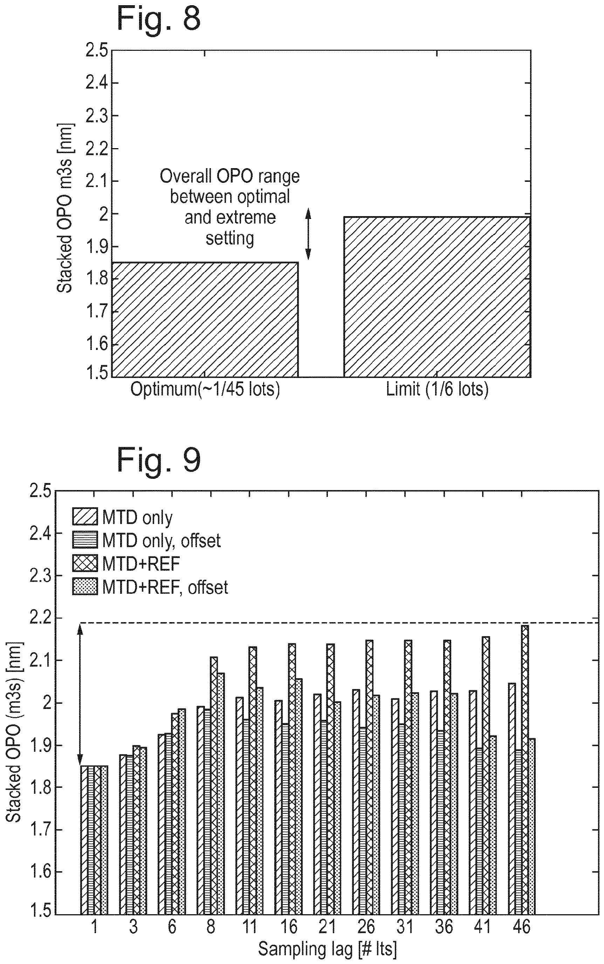

As depicted in Figure 3, lot-to-lot variation of a dataset is broken down into frequency spectra $sp_1$ to $sp_n$ of its inherent lot-to-lot variation per contributor (e.g. ADI, MTD, AEI) by a Fourier transform. This can be done at parameter level or per measurement position. The Fourier transform can be preceded by a modelling step in order to split correctable and non-correctable portions of the overlay (or CD or other measure) fingerprints $f_1$ to $f_n$ contained in the dataset, as well as by splitting average field from wafer contribution (as shown in Figures 8 and 9).

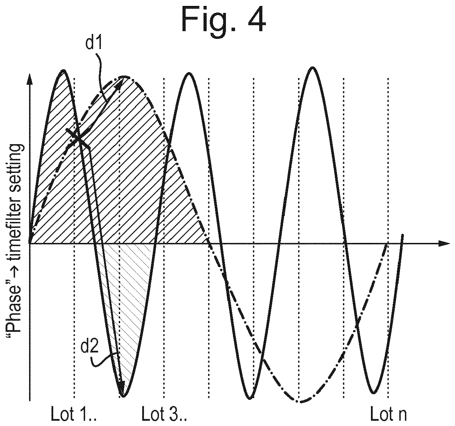

A set of KPIs to determine the optimal time filter transfer function $t_f$ is obtained based on the frequency spectra obtained from the Fourier transform described above. In an embodiment, the time filter setting $t_f$ is a function of frequency that is constant below a certain correction frequency $f_c$ and decreases above the certain correction frequency $f_c$. As shown in Figure 4, the goal of the KPIs is to optimize the ratio between the low frequency components of the lot-to-lot variation that can be fed back constructively (i.e. leading to a reduction in overlay), but are to some extent dampened by the filter, and high frequency components, that can only be fed back destructively (i.e. leading to an increase in overlay), which might be partially passed on by the filter. The constructive region is shown in right hatching in Figure 4 and the destructive region in left hatching. This optimization is done taking into consideration the phase shift that is caused by the time filter itself, and the delay introduced by the fact that corrections based on overlay measurements are typically only applied on subsequent lots. As can be seen in Figure 4, a correction is likely constructive if the delay d1 between a measurement and the correction being applied is much smaller than the period of the error, desirably less than 1/6 of the period of the error. A correction is likely destructive if the delay d2 is equal or higher than half of the period of error.

Since the underlying mathematical equations are much less complex in the frequency domain than in the time domain (convolution and multiplication, respectively), complex filter designs can be realized by solving/optimizing a set of algebraic equations, instead of integral equations, enabling the efficient use of optimizing algorithms such as gradient descent as discussed below.

Further, this approach can be used to develop adaptive filters, that automatically adjust to changes in the frequency composition of the input data generated continuously in a run-to-run scenario.

Below, a simple example of using algebraic equations derived from a frequency domain description of time filtering and delay to optimize parameterized filters is described. The gradient descent approach could be replaced by more elaborate optimizers such as L-BFGS-B (a limited-memory quasi-Newton code for bound-constrained optimization by Ciyou Zhu, Richard Byrd, Jorge Nocedal and Jose Luis Morales) that allow constraints for the parameters to be set such as to avoid negative values or values > 1.

A generalized transfer function describing filtering and delay introduced by the feedback loop is as follows:

$$H(f) = \sum_{m=0}^{l} b_n \times e^{-i2\pi f m} \tag{1}$$

where 1 is the maximum number of parameters or past lots to be taken into account.

The cost function to be minimized is:

$$J(b_1, \ldots, b_l) = \frac{|\hat{A} - \hat{B}|^2}{|\hat{A}|^2} = \frac{\sum_{k=0}^{N-1}(1 - 2|H_k| \cdot \cos(\phi_k) + |H_k|^2) \cdot |\hat{A}_k|^2}{\sum_{n=0}^{N-1}|\hat{A}_k|^2} \tag{2}$$

where $A_k$ is the complex value of a discrete Fourier transform of the lot-to-lot variation at frequency $f_k$.

Optimization via gradient descent gives:

$$b_{i,j} = b_{i,j-1} - \alpha \frac{\partial}{\partial b_i} J(b_1, \dots, b_l) \tag{3}$$

where j is the iteration number and $\alpha$ is the step parameter of gradient descent.

The above approach treats the input data such that the steady state behavior of the time filter (which is important for long term stability) is adjusted independently from its transient/convergence behavior), by first removing the average (or average per substrate holder) contribution from the input data before performing the Fourier transform on the remaining contributor.

Based on the time filter settings determined as above, the lot-to-lot variation per contributor can be broken down into different frequency bands according to: the portion that the time filter can capture constructively (i.e. in a way that reduces lot-to-lot variation); the upper limit of capturable lot-to-lot variation that could be theoretically captured with ideal, zero-lag time filters; and the portion that cannot be captured by a feedback loop due to its high frequency variation.

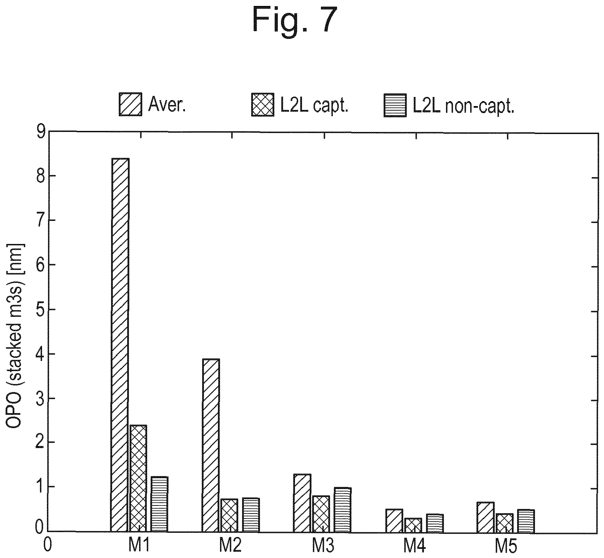

The resulting breakdown of the error provides an overview of the correctable and capturable static and dynamic contributors and their overlay contribution, based on which the relevant components, required model orders, and time filter settings can be chosen to build up an after etch control strategy. An example of such a breakdown is shown in Figure 7. This figure shows a breakdown of on-product overlay budgets at different measurement stages and strategies M1 to M5 split between average (right hatching), lot-to-lot capturable (cross-hatching) and lot-to-lot non-capturable (horizontally hatching) . The breakdown also indicates if different time filters or even approaches (e.g. feedforward) are needed to better capture lot-to-lot variation. It can be recalculated for various choices of available time filters to select the optimal one.

An appropriate choice of above KPI might also directly allow to calculate the above breakdown in the frequency domain directly, without the explicit need to transform back into the time domain, since the power spectral density approach utilized to construct the cost function directly represents the variance of the data set. This allows for a low cost forecast of the performance gain or detriment based on the final value of the cost function after optimization.

With the average substrate removed, the average power spectral density over all points represents the distribution of variance across the frequency range. That the average PSD is equivalent to the variance utilized, e.g. in the stacked m3s overlay metric, can be seen from the following:

$$\sigma^2 = \sum_j^N \sum_i^M \frac{(\bar{x} - x_{ij})^2}{N \cdot M} = \sum_i^M \frac{1}{M} \sum_j^N \frac{1}{N} \left( \sum_m^M \frac{1}{M} \sum_n^N x_{mn} N - x_{ij} \right)^2 \tag{4}$$

where i,m...M are the point indices and j,n...N are the wafer indices. Since the average wafer is removed in cases where $\sigma$ represents the lot-to-lot variation, $\sum_m^M \frac{1}{M} \sum_n^N \frac{x_{mn}}{N} = 0$. Therefore, equation 4 simplifies to

$$\sigma^2 = \sum_i^M \frac{1}{M} \cdot \frac{1}{N} \sum_j^N (x_{ij})^2 = \sum_i^M \frac{1}{M} \cdot \frac{1}{N} \sum_k^N |x_{ik}|^2 \tag{5}$$

where $x_{ik}$ is the discrete Fourier transform at frequency $f_k$, position i. The second part of the equation utilizes Parseval's theorem. Utilizing the definition of the PSD, equation 5 can be expressed as

$$\sigma^2 = \sum_i^M \frac{1}{M} \cdot \sum_k^N PSD_{ik} \tag{6}$$

where $PSD_{ik}$ is the power spectral pensity of point i at frequency $f_k$.

An example of a forecast is shown in Figure 8 which shows the difference in on-product overlay OPO when using an optional time filter frequency and an extreme time filter frequency. An improvement of more than 0.1 nm is achievable for the given dataset.

The above cost function can be extended, in order to derive a second KPI for choice of the appropriate sampling frequency for each contributor, by incorporating the effects of downsampling of the time series representing lot-to-lot variation and the resulting aliasing effects, where frequencies above half of the sampling frequency are wrongly picked up by the control loop as low frequent variations. The cost function changes then to

$$J(b_1, \ldots, b_l) = \frac{|\hat{A} - \hat{B}|^2}{|\hat{A}|^2} = \frac{\sum_{k=0}^{N-1} \left( |\hat{A}_k|^2 - \hat{A}_k H_k^* \hat{A}_{k,ds}^* - \hat{A}_k^* H_k \hat{A}_{k,ds} + |H_k|^2 |\hat{A}_{k,ds}|^2 \right)}{\sum_{k=0}^{N-1} |\hat{A}_k|^2}, \tag{7}$$

where Ak,ds is the component of the Fourier transform of the downsampled signal at frequency fk. Here, the transfer function is modified according to:

$$H = H_{smear} \times H_{EWMA} \tag{8}$$

$$H_{EWMA}(f) = \frac{\lambda}{1 - (1-\lambda) \cdot e^{-i2\pi f \epsilon}} \tag{9}$$

$$H_{smear}(f) = \sum_{\varepsilon=1}^{\epsilon} e^{-i2\pi f \varepsilon} = e^{-i2\pi f \delta} \frac{1 - e^{-i2\pi f \epsilon}}{1 - e^{-i2\pi f}} \tag{10}$$

where is the delay between measurement and correction, and $\varepsilon$ is the sampling "lag", indicating the difference in number of lots between two measurements. In this approach, for each value in a predefined set of $\varepsilon$ the cost function is minimized to yield the optimal time filter settings, then the minimized cost function itself is used.

Figure 9 shows overlay OPO forecasts for different sampling lags. The forecasts shown are metrology-to-device (MTD) with and without offset and after-etch refinement (REF) with and without offset. MTD is a fingerprint typically added on top of after-development fingerprints that represents the lower order part of the after-develop to after-etch bias. Typically this fingerprint is refreshed less frequently than the ADI fingerprint and receives different time filter settings. REF is again an additional component of the after-etch control loop, but this time solely based on after-etch data, representing high to very high order corrections. Figure 9 shows the overlay increase if the sampling frequency for the underlying after-etch measurements is reduced for both MTD and REF (or in other words the sample lag, meaning the delay in lots between two subsequent measurements is increased). Furthermore it is shown that the variability of the resulting on-product overlay in function of the sampling offset (e.g. the difference between measuring lot 1, 4, 7... or 2, 5, 8...) can be quite high as soon as the sampling rate reaches the order of magnitude of the fundamental frequency of the variation of the underlying main overlay component. This is a result of aliasing.

Again, with an appropriate choice of the cost function as above, the effect of reduced sampling rate on the error of interest (e.g. overlay) can be forecast more or less directly with low additional computational effort.

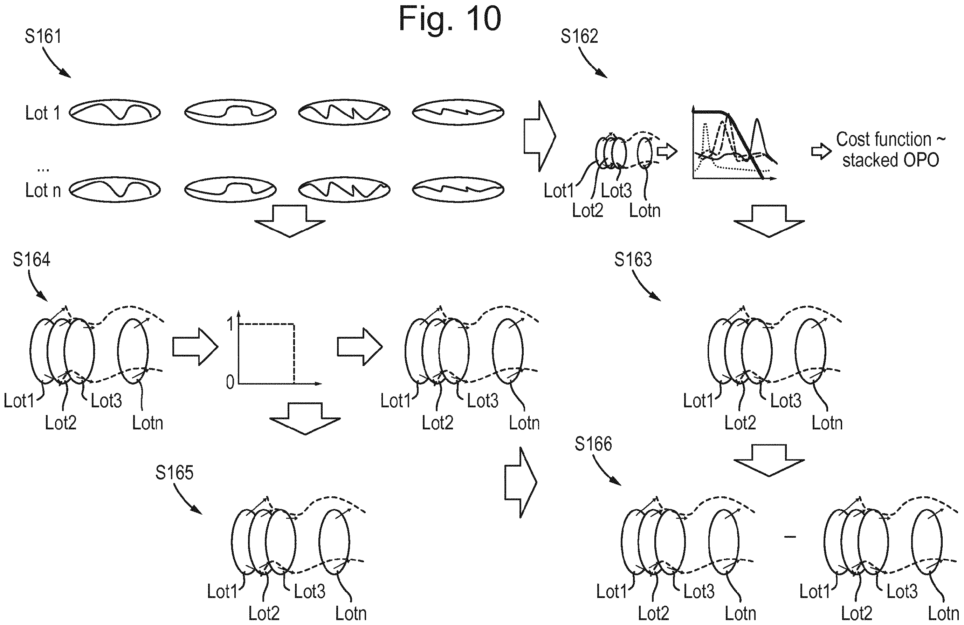

The approach can be extended such that the lot-to-lot "error" fingerprint (each fingerprint representing a certain contributor) caused by aliasing can be determined by applying additional modulation to the original lot-to-lot variation in the frequency domain. This is shown in Figure 10.

In step s161 fingerprints fp1 to fp4 are determined for each lot of wafers. Each fingerprint represents a specific contributor (e.g. ADI, MTD, refinement) to the error. In step S162, these fingerprints for a specific contributor are downsampled in time (meaning all but the fingerprints for the "measured" lots at a given sample rate are set to 0). Then the time filter settings are optimized for the given sample rate and contributor.

In step S163, the resulting lot-to-lot variation is calculated, taking into account the time filter setting from step S162 and additional transfer function describing the resulting lot-to-lot fingerprint being stable in between measured lots (Eq.10).

In Step S164, the fingerprints from step S161 for the specific contributor are taken and the lot-to-lot variation component is again extracted. If a dual stage lithographic apparatus is used then the lot-to-lot variation may be calculated per substrate stage. Then the fingerprints are transformed into the frequency domain and all high frequency components above half of the sampling rate (the Nyquist frequency) are set to 0, and the fingerprints are transformed back into the time domain.

Then in step S165, the resulting fingerprints are downsampled again in time according to the sampling rate from step S162 and the resulting lot-to-lot variation is calculated after application of the time filter with the time filter settings from step S162.

In step S166, the delta between the lot-to-lot variation fingerprints obtained in steps S163 and S165 is calculated. The delta represents the effect of the frequency content of the lot-to-lot variation above the Nyquist frequency upon downsampling and is further referred to as the "aliasing fingerprint". This process is repeated for all applicable sampling rates and contributors. In a run-to-run control situation, this "error" fingerprint will manifest itself both as additional low-frequency component of the resulting lot-to-lot variation of the error of interest, as well as an additional average (DC) offset depending on the magnitude of the aliasing.

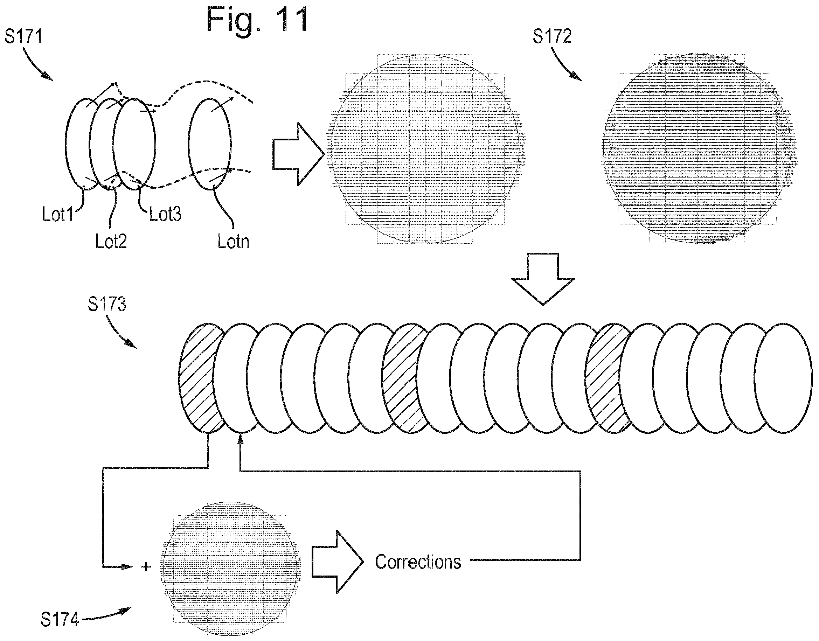

Provided that the average part of this aliasing fingerprints is stable over time, the average portion of fingerprint that was determined mathematically via a set of Fourier transformations and modulations in the frequency domain can then be utilized in order to compensate for this introduced average offset in a run-to-run situation with reduced sampling frequency, by applying it as a constant correction offset to the control loop. This is shown in Figure 11 which depicts first the determination of the aliasing fingerprint on a first set of very frequently measured data (step S171) and the application of the average part of the aliasing fingerprint as a non-zero offset in step S172, when the control loop is indeed based on infrequent measurement of the control fingerprints according to the sampling rate for which the aliasing fingerprint was calculated.

The second main step, of optimizing the control strategy, can realized by the following substeps.

The KPIs derived in the first main step, of building a strategy, can be applied locally, that means per measurement position. As such, candidate sampling positions can be selected or eliminated based on:

- The (low frequency) capturable vs. (high frequency) non-capturable content they carry (taking into account the optimized time filter setting derived earlier).
- The amount of aliasing they would introduce due to their high frequency content of the local error signal at that particular position in case of reduced sampling rates (again taking into account the optimized time filter setting derived earlier).

The sampling distributions can then be further optimized using existing techniques such as sampling scheme and target layout optimization to optimize inter- and intra-field distributions, respectively. The required number of sampling points could be derived using existing KPIs such as systematic and random residuals.

However, high density spatial measurements that might only become available after a pattern transfer step (e.g. etching) might require an additional degree of (co-)optimization in order to balance metrology load against performance potential, in order to fit, for example, Q-time constraints that exist after etching, where wafers have to arrive at the next process step within a certain timeframe. This can be achieved by combining KPIs for spatial sampling optimization (e.g. systematic residuals) with aforementioned KPIs for temporal optimization in order to minimize the overall error of interest. A potential outcome of this optimization might be, that spatial sampling density is reduced in order to enable more frequent measurements, such as to slightly reduce the capture efficiency for the average fingerprint, while significantly capturing and reducing lot-to-lot variation.

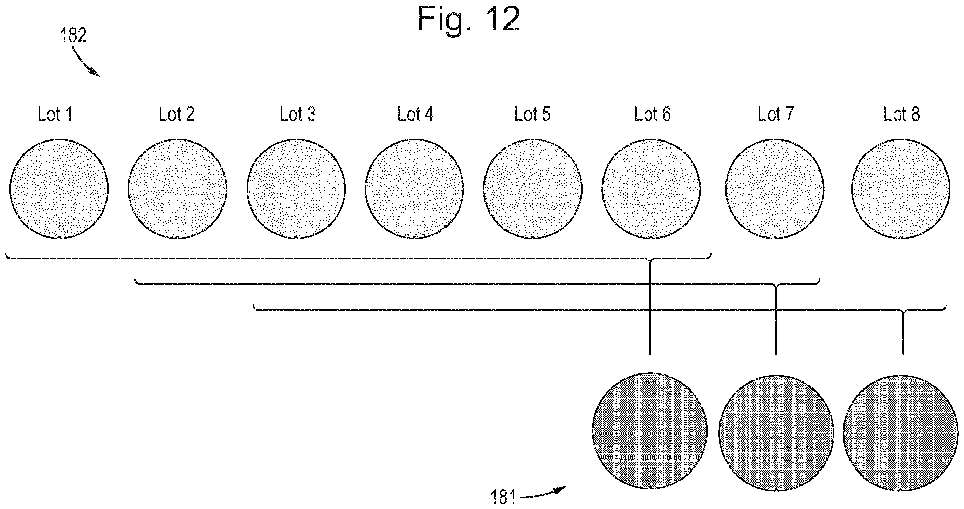

As shown in Figure 12, a trade-off between sampling density and frequency can be further relaxed by distributing a dense sampling scheme 181 as several less dense sampling schemes 182-184 over multiple lots. The number of lots over which to distribute the sampling and the density of the combined sampling can be derived using the KPIs discussed above and a combination of KPIs.

The correction models can be optimized, by either introducing further granularity in the recommendation of time filter settings/parameters, through allowing to define custom and optimized time filters per model correctable terms, or by eliminating modelling terms that do not vary in the right frequency band, causing destructive feedback or even aliasing.

Having individual time filter settings per model parameter might introduce too much complexity into the control loop, if the total number of utilized model parameters is high. Model parameters with similar temporal behavior might therefore be grouped together based on their frequency spectra, such that a global time filter setting per group can be recommended.

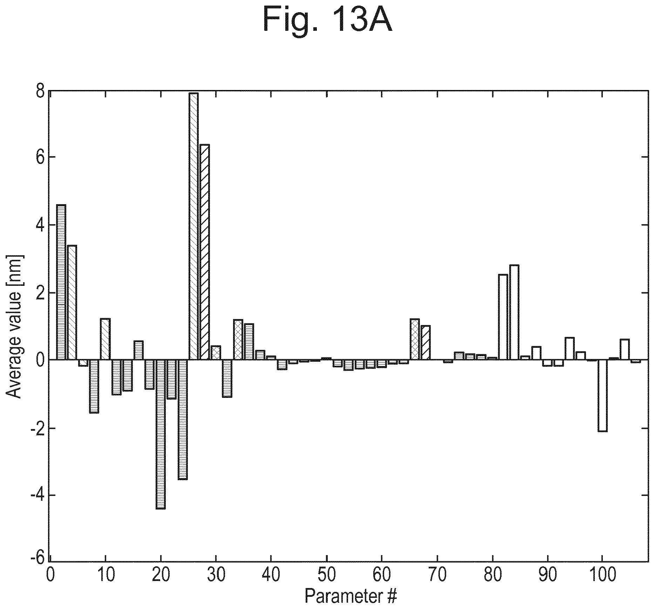

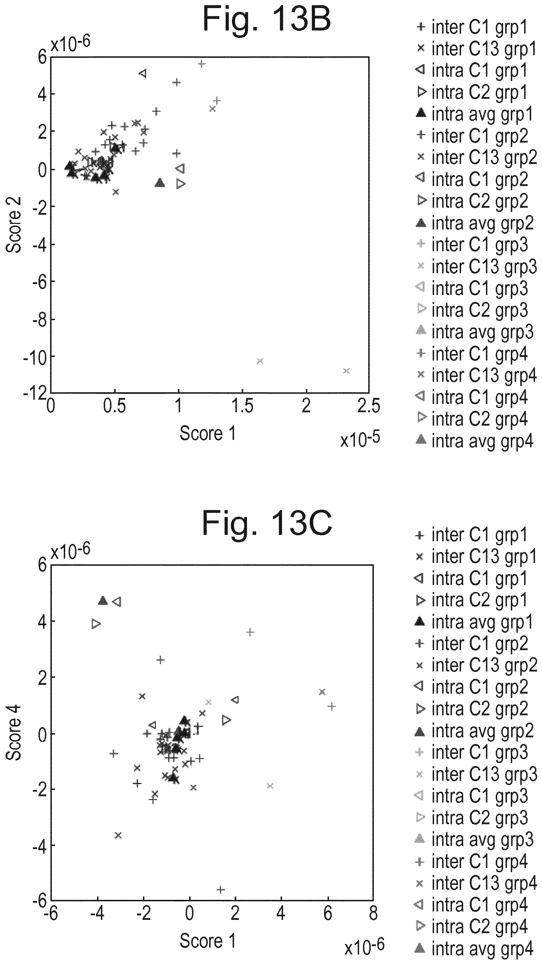

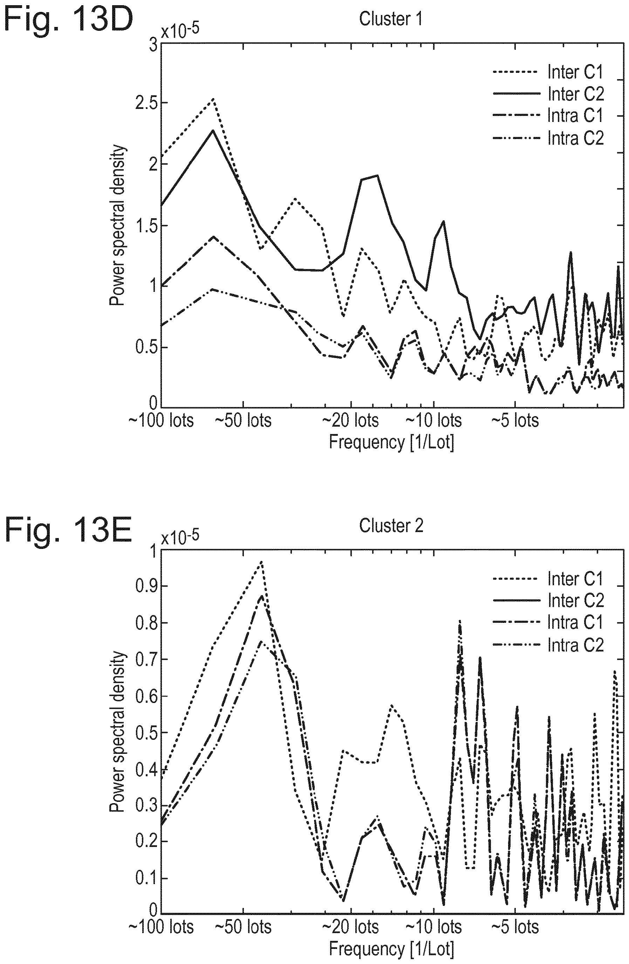

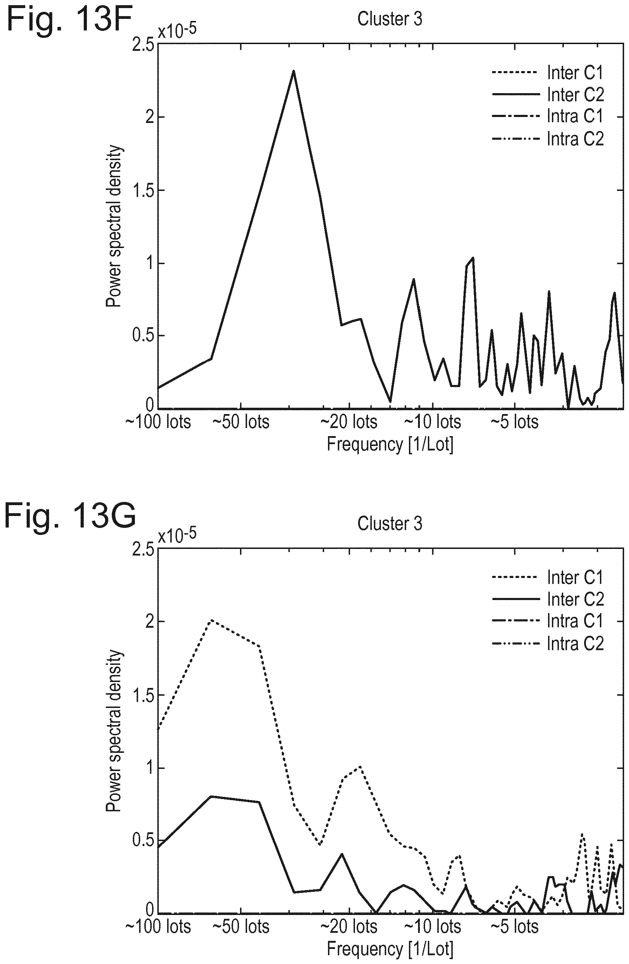

Figures 13A to G show grouping of model parameters as a result of first applying PCA to the collection of frequency spectra per contributor. Figure 13A shows the contribution of each parameter to the average fingerprint. Figures 13B and 13C show the location of each model parameter in the space spanned by the first four principal components (i.e. principal frequency spectra). This can then be used to cluster parameters with similar frequency spectra together, as represented by the different shades and indicated in the key. The resulting accumulated frequency spectra for each of parameter clusters 1 to 4 are shown in Figures 13D to G.

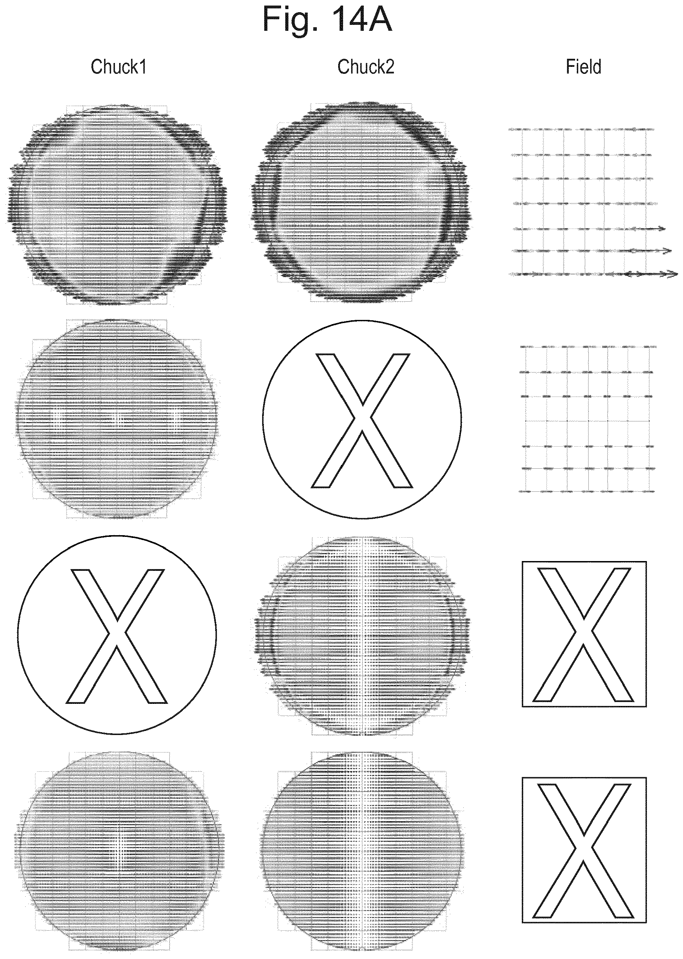

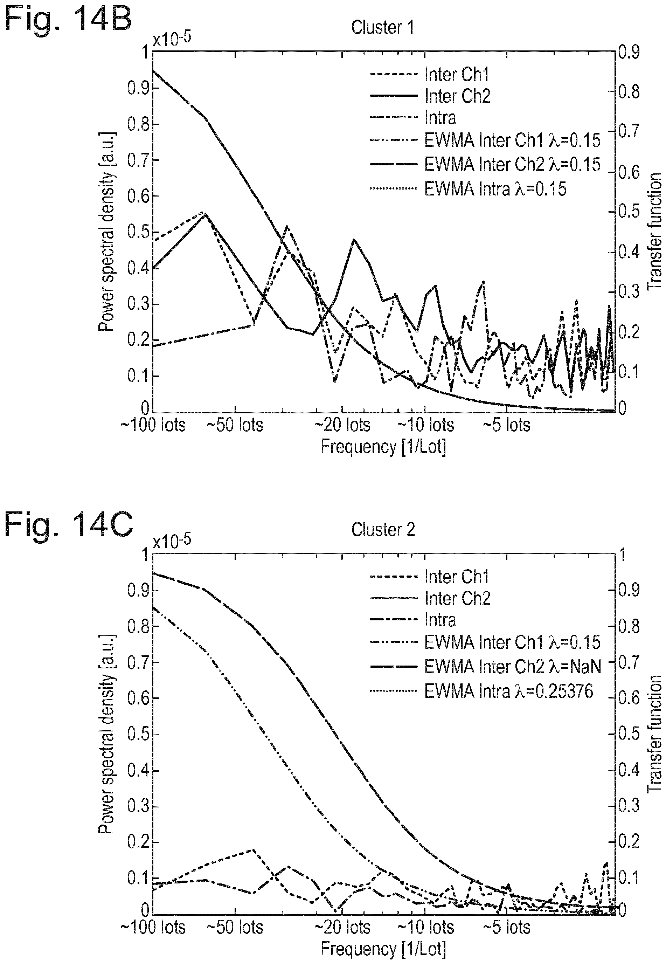

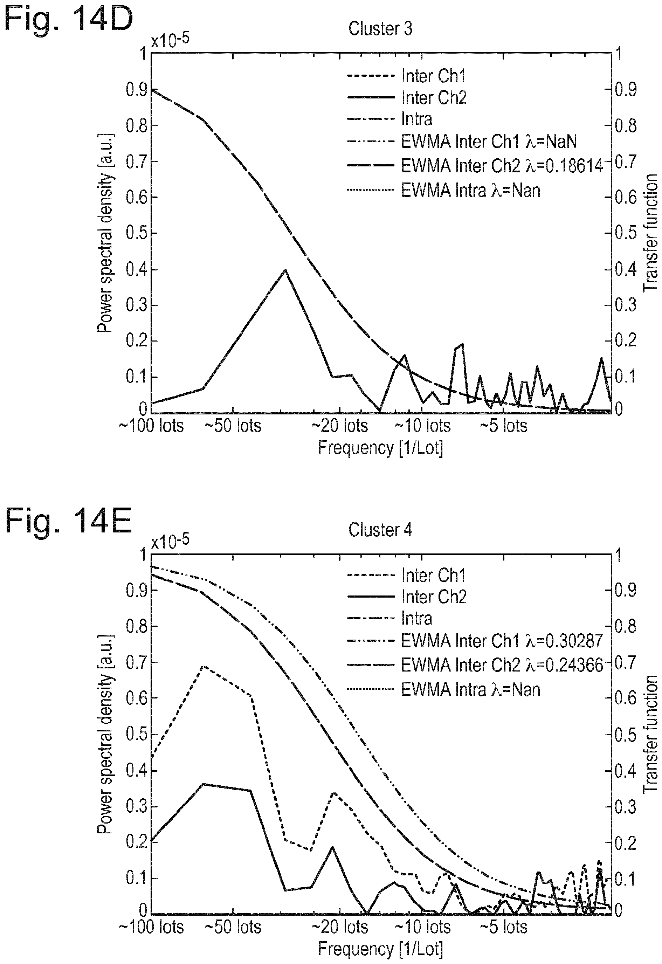

Figures 14A to E show fingerprints reconstructed and timefilter optimization per parameter group. Figure 14A shows the reconstruction of lot-to-lot fingerprints for each of parameter groups 1 to 4. The fingerprints are further split into substrate holder (chuck) 1 interfield (i.e. wafer) fingerprint, chuck2 interfield fingerprint and average field fingerprint. For groups that do not contain two substrate holder parameters, the corresponding fingerprint is crossed out, since not available. Figures 14B to 14E show the resulting frequency spectra per parameter group (this time accumulated using the total fingerprints on the left via pointwise FFT) further split into inter and intrafield. Also shown for each group of spectra are the corresponding optimized time filter transfer functions, with the optimized lambda values shown in the legend.

Grouping (or clustering) of parameters can also be used in order to deal with parameters, that are correlated amongst each other, such as intrafield "k"-parameters, representing regular polynomials which are non-orthogonal, by assigning these parameters to the same group.

The above-described approach to determine the "average" aliasing error can be applied to parameter selection or elimination, by comparing the average aliasing error per parameter to the contribution of the parameter to the average fingerprint (see Figure 13A). If the aliasing error is higher than the actual "useful" contribution, the parameter is to be eliminated.

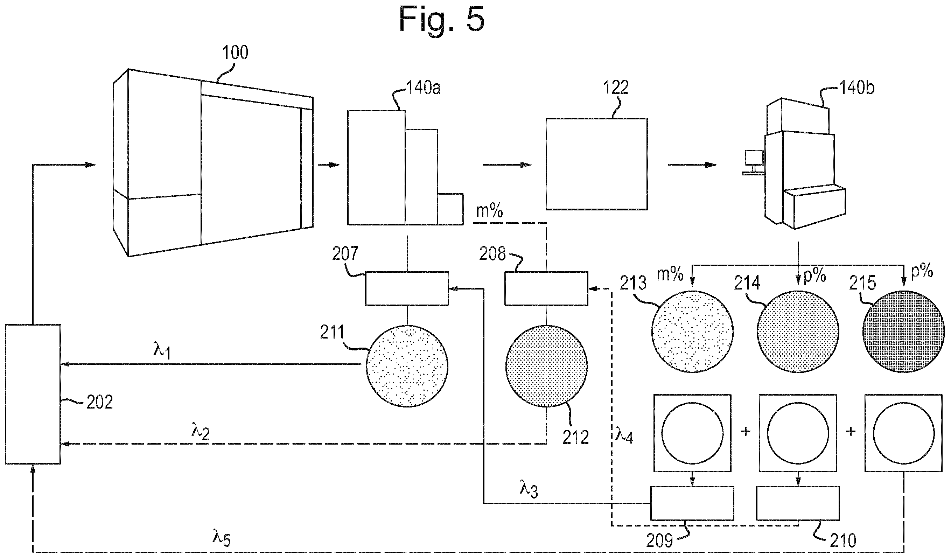

Another control system in which the invention can be applied is depicted in Figure 5. In the drawings, parts that are the same as in the system of Figure 2 are depicted with the same references and not described further.

In the control scheme of Figure 5, after development some wafers of each lot are measured with a standard sampling scheme 211 and the measurement results fed back to controller 202 with time constant $\lambda_1$. Another proportion, e.g. n% of lots, are measured with a dense sampling scheme 212 and the measurement results fed back to controller 202 with time constant $\lambda_2$.

After the pattern transfer step (such as an etch), m% of lots are measured with standard sampling scheme 213, p% with dense sampling scheme 214 and q% with hyper-dense sampling scheme 215. The measurement results from sampling scheme 213 are fed back and combined 207 with the results from standard sampling of after-development substrates with time constant $\lambda_3$. The measurement results from dense sampling scheme 214 are fed back and combined 208 with the results from dense sampling of after-development substrates with time constant $\lambda_4$. The measurement results from hyper-dense sampling scheme 215 are fed back to controller 202 with time constant $\lambda_5$. Additional contributors can also be included.

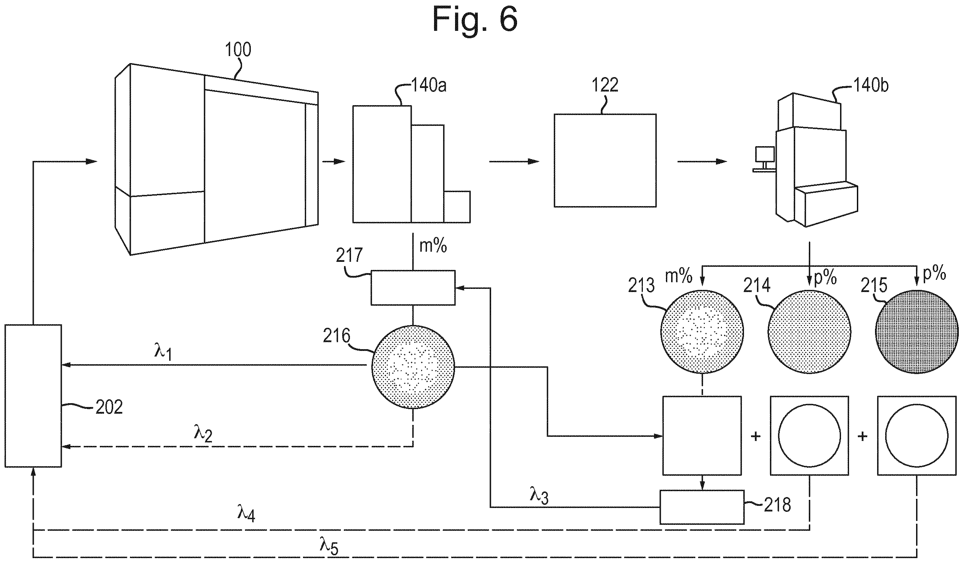

Another control system in which the invention can be applied is depicted in Figure 6. In the drawings, parts that are the same as in the systems of Figures 2 and 5 are depicted with the same references and not described further.

In the control scheme of Figure 6, after development some wafers of each lot are measured with a standard sampling scheme 216 and the measurement results fed back to controller 202 with time constant $\lambda_1$. The same substrates are measured with another sampling scheme 212 and the measurement results fed back to controller 202 with time constant $\lambda_2$. After the pattern transfer step (such as an etch), m% of lots are measured with standard sampling scheme 213, p% with dense sampling scheme 214 and q% with hyper-dense sampling scheme 215. The measurement results from sampling scheme 213 are fed back 218 and combined 207 with the results from standard sampling of after-development substrates with time constant $\lambda_3$. The measurement results from dense sampling scheme 214 are fed back and combined 208 with the results from dense sampling of after-development substrates with time constant $\lambda_4$. The measurement results from hyper-dense sampling scheme 215 are fed back to controller 202 with time constant $\lambda_5$.

It will be appreciated that the invention can be used with other control schemes and variations on these control schemes.

In summary, embodiments of the present invention can enable identification of relevant frequency domains based on available multi lot data. This then enables determination of sampling frequencies and time filter settings in order to accurately capture and correct the correctable variation in the respective frequency domain and avoid penalties introduced by under sampling and/or destructive feedback. KPIs can be setup so as to directly represent the on-product overlay impact of the respective recommended settings. KPIs could also be modified as to represent other metrics relevant to yield such as "number of dies in spec".

Embodiments of the invention also provide frequency domain based budget breakdowns to accurately forecast correctable overlay content per after-etch control strategy contributor and per frequency domain, accurately taking into account effects of time filtering and by extension sampling rate, in order to assist selection and control setup of the valid contributors for the after-etch control strategy.

Embodiments of the invention also provide low-cost optimization approaches to customize time filter coefficients according to the frequency content of the variation to be captured/controlled. This approach can be extended to dynamically updating the time filter parameters based on the generated monitoring data in a run-to-run control scenario. In the embodiments described above, filtered measurement data is used to apply corrections to a lithography step. It will be appreciated that corrections can also be applied in other steps of a lithographic process, for example a pattern transfer step such as etching.

Also enabled in embodiments of the invention is the possibility to partially compensate for the detrimental effects of under-sampling (measuring at lower sampling rates) by calculating correctable offsets representing the fingerprints introduced by "aliasing".

Frequency-sensitive sampling point and model parameter selection (including frequency domain based parameter grouping for optimizing time filtering per parameter), as well as co-optimization of sampling density and sampling rate are also achievable in embodiments of the invention.

The present invention enables a control strategy to be built and optimized more quickly than known methods because, generally, frequency domain based calculations are computationally less expensive (O(N logN)) than time-domain computations ($O(N^2)$). This is especially useful for optimization calculations and can enable dynamic, real time updates of time filter parameters.

Control strategies derived using the invention can be more accurate, leading to higher yield. The straightforwardness of the approach helps to produce more accurate recommendations for overlay control loops that translate into improved overlay performance and hence higher yield. Moreover, the generated fingerprints, e.g. describing the effects of under-sampling, might be used to partially compensate for these effects.

Proactive use of the present invention can enable ramp phases to be finished faster (from a control loop point of view), compared to when the required settings are derived reactively, e.g. via statistical process control.

The approaches described above can be extended to or executed on per substrate level, in order to minimize substrate-to-substrate variation concurrently with the lot-to-lot variation.

The present invention provides methods and KPIs to optimize time filter settings and sampling rates. Methods of the invention are based on a frequency domain approach. Desirably, the input data set is representative in terms of variation of the process.

Embodiments of the invention can employ a wide variety of time filters, for example:

- Bessel filters
- Butterworth filters
- Matched filters
- Elliptical filters (Cauer filters)
- Linkwitz-Riley filters
- Chebyshev filters
- Biquad filters
- High-pass filters
- Low-pass filters
- Band-pass filters
- Infinite impulse response filters
- Finite impulse response filters
- Bilinear transforms
- Kalman filters
- Savitzky-Golay filters

It is also possible to use multiple filters in series or in parallel to filter inputs for a single controllable process parameter. In an embodiments, a first filter is applied to measurement data of the measurement data time series relating to a first zone of the substrates and a second filter, different from the first filter, is applied to measurement data of the measurement data time series relating to a second zone of the substrates. For example, measurement data relating to edge dies can be treated differently than measurement date relating to interior dies.

Further embodiments of the invention are disclosed in the list of numbered clauses below:

1. A method for generating a control scheme for a device manufacturing process, the method comprising:

   obtaining a measurement data time series of a plurality of substrates on which an exposure step and a process step have been performed;
   transforming the measurement data time series to obtain frequency domain data; and
   determining, using the frequency domain data, a control scheme to be performed on subsequent substrates.

2. A method according to clause 1, wherein determining the control scheme comprises determining a time filter to be applied to measurements of the subsequent substrates.
3. A method according to clause 1 or 2, wherein determining the control scheme comprises determining coefficients of a time filter to be applied to measurements of the subsequent substrates.
4. A method according to clause 2, 3 or 4, wherein determining the control scheme comprises updating coefficients of a time filter in response to measurements of the subsequent substrates.
5. A method according to any one of the preceding clauses wherein, determining the control scheme comprises determining a sampling scheme to be applied to measurements of the subsequent substrates.
6. A method according to clause 6, wherein determining a sampling scheme comprises determining a spatial sampling scheme to be applied to measurements of the subsequent substrates.
7. A method according to clause 6 or 7, wherein determining a sampling scheme comprises determining a temporal sampling scheme to be applied to measurements of the subsequent substrates.
8. A method according to clause 7, further comprising determining an error offset introduced by the temporal sampling scheme on the basis of measurements of subsequent substrates and determining an improved temporal sampling scheme to compensate said error offset and to be applied in the process control scheme of a subsequent set of substrates.

9. A method according to clause 7 or 8 when dependent on clause 6, wherein determining a sampling scheme comprises determining a spatial sampling scheme and a temporal sampling scheme that are co-optimized.

10. A method according to any one of the preceding clauses, wherein determining a control scheme comprises determining a control scheme that includes first measurements at a first point in the manufacturing process and second measurements at a second point in the manufacturing process, the second point being subsequent to the first point.

11. A method according to clause 10, wherein determining a control scheme comprises determining a first sampling scheme for the first measurements and a second sampling scheme for the second measurements.

12. A method according to clause 10 or 11, wherein determining a control scheme comprises determining a first time filter to be applied to the first measurements and a second time filter to be applied to the second measurements.

13. A method according to clause 10, 11 or 12, wherein the first point is before a process step and the second point is after the process step.

14. A method according to any one of the preceding clauses, wherein the measurement data time series includes measurements of a plurality of different parameters of the substrates and determining a control scheme comprises determining a control scheme to be applied to measurements of at least two of the plurality of different parameters.

15. A method according to clause 14 wherein the process step is at least one process selected from the group of: etching, annealing, implantation, deposition, and polishing.

16. A method according to any one of the preceding clauses further comprising predicting a residual error budget after use of the control scheme.

17. A method according to any one of the preceding clauses wherein the control scheme is to be applied to correct at least one of overlay, dose and focus.

18. A computer program comprising computer readable code means for instructing a computer system to perform a method according to any one of the preceding clauses.

19. A device manufacturing process comprising:

> exposing an initial set of substrates using a lithographic apparatus;
> performing a process step on the initial set of substrates;
> measuring a parameter of a plurality of the initial set of substrates to obtain a measurement data time series;
> transforming the measurement data time series to obtain frequency domain data;
> determining, using the frequency domain data, a control scheme to be performed on subsequent substrates; and
> exposing subsequent substrates using the control scheme.

Examples of process parameters to which the present invention can be applied include: overlay, CD, CDU, sidewall angle, line edge roughness and focus. Markers and measurement techniques suitable for measuring these parameters are well known in the art.

While specific embodiments of the invention have been described above, it will be appreciated that the invention may be practiced otherwise than as described.

An embodiment may include a computer program containing one or more sequences of machine-readable instructions configured to instruct various apparatus as depicted in Figure 1 to perform measurement and optimization steps and to control a subsequent exposure process as described above. This computer program may be executed, for example, within the control unit LACU or the supervisory control system SCS of Figure 1 or a combination of both. There may also be provided a data storage medium (e.g., semiconductor memory, magnetic or optical disk) having such a computer program stored therein.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 1-100 nm), as well as particle beams, such as ion beams or electron beams. Implementations of scatterometers and other inspection apparatus can be made in UV and EUV wavelengths using suitable sources, and the present disclosure is in no way limited to systems using IR and visible radiation.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method for generating a control scheme for a device manufacturing process, the method comprising:

   obtaining a measurement data time series of a plurality of substrates on which an exposure step and a process step have been performed;
   transforming the measurement data time series to obtain frequency domain data; and
   determining, using the frequency domain data, a control scheme to be performed on subsequent substrates.

2. A method according to claim 1, wherein determining the control scheme comprises determining a time filter to be applied to measurements of the subsequent substrates.

3. A method according to claim 1 or 2, wherein determining the control scheme comprises determining coefficients of a time filter to be applied to measurements of the subsequent substrates.

4. A method according to claim 2, 3 or 4, wherein determining the control scheme comprises updating coefficients of a time filter in response to measurements of the subsequent substrates.

5. A method according to any one of the preceding claims wherein, determining the control scheme comprises determining a sampling scheme to be applied to measurements of the subsequent substrates.

6. A method according to claim 6, wherein determining a sampling scheme comprises determining a spatial sampling scheme to be applied to measurements of the subsequent substrates.

7. A method according to claim 6 or 7, wherein determining a sampling scheme comprises determining a temporal sampling scheme to be applied to measurements of the subsequent substrates.

8. A method according to claim 7, further comprising determining an error offset introduced by the temporal sampling scheme on the basis of measurements of subsequent substrates and determining an improved temporal sampling scheme to compensate said error offset and to be applied in the process control scheme of a subsequent set of substrates.

9. A method according to claim 7 or 8 when dependent on claim 6, wherein determining a sampling scheme comprises determining a spatial sampling scheme and a temporal sampling scheme that are co-optimized.

10. A method according to any one of the preceding claims, wherein determining a control scheme comprises determining a control scheme that includes first measurements at a first point in the manufacturing process and second measurements at a second point in the manufacturing process, the second point being subsequent to the first point.

11. A method according to claim 10, wherein determining a control scheme comprises determining a first sampling scheme for the first measurements and a second sampling scheme for the second measurements.

12. A method according to claim 10 or 11, wherein determining a control scheme comprises determining a first time filter to be applied to the first measurements and a second time filter to be applied to the second measurements.

13. A method according to claim 10, 11 or 12, wherein the first point is before a process step and the second point is after the process step.

14. A method according to any one of the preceding claims, wherein the measurement data time series includes measurements of a plurality of different parameters of the substrates and determining a control scheme comprises determining a control scheme to be applied to measurements of at least two of the plurality of different parameters.

**15.** A method according to claim 14 wherein the process step is at least one process selected from the group of: etching, annealing, implantation, deposition, and polishing.

# Fig. 1

# Fig. 2

# Fig. 3

# Fig. 4

Fig. 5

# Fig. 6

EP 3 734 364 A1

# Fig. 7

# Fig. 8

# Fig. 9

# Fig. 10

# Fig. 11

S171

Lot1  Lot2  Lot3  Lotn

S172

S173

S174  +  Corrections

EP 3 734 364 A1

# Fig. 12

182

Lot 1    Lot 2    Lot 3    Lot 4    Lot 5    Lot 6    Lot 7    Lot 8

181

EP 3 734 364 A1

# Fig. 13A

## Fig. 13B

+ inter C1 grp1
× inter C13 grp1
◁ intra C1 grp1
▷ intra C2 grp1
▲ intra avg grp1
+ inter C1 grp2
× inter C13 grp2
◁ intra C1 grp2
▷ intra C2 grp2
▲ intra avg grp2
+ inter C1 grp3
× inter C13 grp3
◁ intra C1 grp3
▷ intra C2 grp3
▲ intra avg grp3
+ inter C1 grp4
× inter C13 grp4
◁ intra C1 grp4
▷ intra C2 grp4
▲ intra avg grp4

## Fig. 13C

+ inter C1 grp1
× inter C13 grp1
◁ intra C1 grp1
▷ intra C2 grp1
▲ intra avg grp1
+ inter C1 grp2
× inter C13 grp2
◁ intra C1 grp2
▷ intra C2 grp2
▲ intra avg grp2
+ inter C1 grp3
× inter C13 grp3
◁ intra C1 grp3
▷ intra C2 grp3
▲ intra avg grp3
+ inter C1 grp4
× inter C13 grp4
◁ intra C1 grp4
▷ intra C2 grp4
▲ intra avg grp4

Fig. 13D

Fig. 13E

# Fig. 13F

Cluster 3

# Fig. 13G

Cluster 3

# Fig. 14A

Chuck1           Chuck2           Field

## Fig. 14B

## Fig. 14C

## Fig. 14D

Cluster 3

Legend:
- Inter Ch1
- Inter Ch2
- Intra
- EWMA Inter Ch1 $\lambda$=NaN
- EWMA Inter Ch2 $\lambda$=0.18614
- EWMA Intra $\lambda$=Nan

## Fig. 14E

Cluster 4

Legend:
- Inter Ch1
- Inter Ch2
- Intra
- EWMA Inter Ch1 $\lambda$=0.30287
- EWMA Inter Ch2 $\lambda$=0.24366
- EWMA Intra $\lambda$=Nan

Europäisches
Patentamt

European
Patent Office

Office européen
des brevets

# EUROPEAN SEARCH REPORT

Application Number

EP 19 17 1535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D<br>A | WO 2018/228750 A1 (ASML NETHERLANDS BV [NL]) 20 December 2018 (2018-12-20)<br>* abstract *<br>* figures 1,8 *<br>* paragraphs [0002], [0004] - [0006], [0028] - [0036] * | 1-7,<br>10-15<br>8,9 | INV.<br>G03F7/20<br>G05B19/418<br>H01L21/66 |
| A | DAVID CROW, ETIENNE JOUBERT, ALAN CARLSON, IRIT K.ABRAMOVICH, DORIT KARLIKAR, ET AL.: "Enhancement of photolithographicperformance by implementing anadvanced process control system", PROC. SPIE 5378, DATA ANALYSIS ANDMODELING FOR PROCESS CONTROL, vol. 5378, 29 April 2004 (2004-04-29), XP040182866, Santa Clara, California, United States DOI: 10.1117/12.535554 * the whole document * | 1-15 | |

TECHNICAL FIELDS
SEARCHED      (IPC)

G03F
G05B
H01L

The present search report has been drawn up for all claims

| Place of search | Date of completion of the search | Examiner |
|---|---|---|
| Munich | 4 November 2019 | Andersen, Ole |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 19 17 1535

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2019

| Patent document cited in search report | Publication date | Patent family member(s) | Publication date |
|---|---|---|---|
| WO 2018228750 A1 | 20-12-2018 | EP 3415988 A1<br>TW 201905967 A<br>WO 2018228750 A1 | 19-12-2018<br>01-02-2019<br>20-12-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012008127 A1

- WO 2018228750 A1